# EUROPEAN PATENT APPLICATION

(11) **EP 4 727 320 A1**
(43) Date of publication of application: **15.04.2026**
(21) Application number: 24819358.3
(22) Date of filing: 05.06.2024
(51) Int. Cl.: H10N 10/00, H01L 25/07, H01L 25/18, H10N 15/00

(54) **SEMICONDUCTOR MODULE, ABNORMALITY DETERMINATION SYSTEM, AND ABNORMALITY DETERMINATION METHOD**

(30) Priority: 08.06.2023 JP 2023095139
(71) Applicant: Topologic Inc., Tokyo 113-8485 (JP)
(72) Inventor: TAKAHASHI, Arata, Tokyo 113-8485 (JP)
(74) Representative: Winter, Brandl - Partnerschaft mbB
(86) International application number: PCT/JP2024/020529
(87) International publication number: WO 2024/253130

(57) **Abstract**

According to one embodiment of the present invention, a semiconductor module is provided. This semiconductor module is provided with: a circuit board on which a semiconductor device is mounted; and a heat-flow sensor which is disposed at a location where a heat-flow is generated as a consequence of the semiconductor device generating heat.

## Description

### BACKGROUND

The present disclosure relates to a semiconductor module, an abnormality determination system, and an abnormality determination method.

### RELATED ART

Patent Document 1 discloses a semiconductor module provided with a heat sink for enhancing a heat dissipation property.

### PRIOR ART DOCUMENTS

### Patent document

[Patent Document 1] JP 2024-13124 A

### SUMMARY

### Problems to be Solved by Invention

In a semiconductor module, thermal stress accompanying heat generation of a semiconductor device can cause delamination (interfacial failure) at an interface between members, for example, between a circuit board and a base. When such interfacial delamination occurs, the temperature of the semiconductor device rises due to heat retention, and abnormalities such as a reduction in the lifetime of the semiconductor device and failures occur. Although design margin is ensured for the semiconductor module through reliability tests, unforeseeable interfacial delamination may occur depending on the environment in which the semiconductor module is used.

### Means for Solving Problems

According to an aspect of the present disclosure, a semiconductor module is provided. The semiconductor module includes a circuit board on which a semiconductor device is mounted; and a heat flow sensor disposed at a position where heat flow associated with heat generation of the semiconductor device occurs.

With such a configuration, the heat flow sensor can detect heat retention accompanying interfacial delamination between members of the semiconductor module, thereby enabling prediction of the occurrence of abnormalities in the semiconductor module, which is less susceptible to influences of the usage environment.

### BRIEF DESCRIPTION OF DRAWINGS

[FIG.1] FIG. 1 is a diagram illustrating an overview of an abnormality determination system 1 according to one aspect.
[FIG.2] FIG. 2 is a schematic cross-sectional view illustrating one example of a semiconductor module 2.
[FIG.3] FIG. 3 is a schematic side view of a heat flow sensor 29A utilizing an anomalous Nernst effect.
[FIG.4] FIG. 4 is a schematic plan view of a thermoelectric conversion unit 292.
[FIG.5] FIG. 5 is a schematic plan view of a first thermoelectric conversion device 292A.
[FIG.6] FIG. 6 is a schematic cross-sectional view showing an arrangement pattern of a heat flow sensor in the semiconductor module 2.
[FIG.7] FIG. 7A and FIG. 7B are schematic cross-sectional views showing arrangement patterns of the heat flow sensor in the semiconductor module 2.
[FIG.8] FIG. 8A and FIG. 8B are schematic cross-sectional views showing other examples of the arrangement pattern of the heat flow sensor in the semiconductor module 2.
[FIG.9] FIG. 9 is a block diagram showing a hardware configuration of an information processing apparatus 4.
[FIG.10] FIG. 10 is a diagram illustrating an example of functional units included in a processor 43.
[FIG.11] FIG. 11 is a graph illustrating an example of the time variation of the output of the heat flow sensor 29A.
[FIG.12] FIG. 12 is an activity diagram showing an example of a flow of information processing executed in the abnormality determination system 1.

### DETAILED DESCRIPTION

Hereinafter, an embodiment of the present disclosure will be described with reference to drawings. Various features described in the embodiment below can be combined with each other.

A program for implementing software described in one embodiment may be provided as a non-transitory computer-readable storage medium, may be made available for download from an external server, or may be provided in such a manner that the program can be activated on an external computer to implement functions thereof on a client terminal (so-called cloud computing).

In various types of information processing according to one embodiment, an input and an output corresponding to the input can be realized. Here, as long as an output is obtained as a result of the input, the form of information referred to in such information processing (hereinafter referred to as reference information) is not limited. The reference information may be, for example, rule-based information such as a database, a look-up table, a predefined function (including a decision formula such as a regression equation constructed by statistical methods), may be a trained model in which the correlation between an input and an output has been learned in advance, or may be a large-scale language model capable of outputting a desired result by inputting a prompt.

In one embodiment, the term "unit" may also include, for example, a combination of hardware resources implemented by a circuit in a broad sense, and information processing performed by software that may be specifically implemented by such hardware resources. Furthermore, various kinds of information are handled in one embodiment, and such information may be represented by, for example, physical values of signal values representing voltage and current, high and low signal values as a set of binary bits consisting of 0 or 1, or quantum superposition (so-called qubits), and communication and computation may be executed on a circuit in a broad sense.

Furthermore, the term "circuit in a broad sense" refers to a circuit that is implemented by appropriately combining at least one or more of a circuit, circuitry, a processor, memory, and the like. The processor may be a general-purpose processor or a dedicated circuit. In other words, the term "circuit in a broad sense" includes an application specific integrated circuit (ASIC), a programmable logic device (e.g., a simple programmable logic device (SPLD), a complex programmable logic device (CPLD), a field programmable gate array (FPGA)), and the like.

### 1. Overview of Abnormality Determination System 1

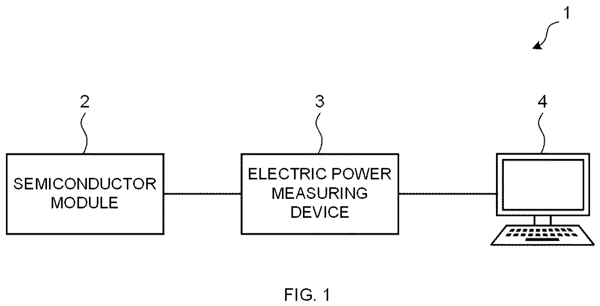

This section describes an overview of an abnormality determination system 1. FIG. 1 is a diagram illustrating an overview of the abnormality determination system 1 according to one aspect.

As shown in FIG. 1, the abnormality determination system 1 includes a semiconductor module 2, an electric power measuring device 3, and an information processing apparatus 4. The abnormality determination system 1 is configured to determine an abnormality in the semiconductor module 2.

### <Semiconductor Module 2>

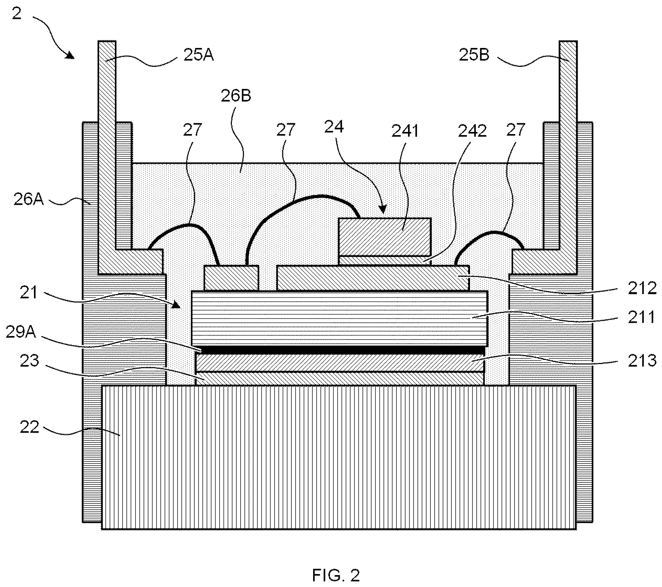

FIG. 2 is a schematic cross-sectional view illustrating one example of the semiconductor module 2. The semiconductor module 2 includes a circuit board 21, a base 22, a bonding layer 23, a semiconductor device 24, a first terminal 25A, a second terminal 25B, a frame body 26A, a sealing material 26B, bonding wires 27, and a heat flow sensor 29A.

### <Circuit Board 21>

The circuit board 21 is a board on which the semiconductor device 24 is mounted. The circuit board 21 includes a substrate layer 211, a first wiring layer 212, and a second wiring layer 213.

The substrate layer 211 is a plate-like member formed of an insulator such as an insulating resin or an insulating ceramic. The first wiring layer 212 is laminated on one surface of the substrate layer 211 (the upper plate surface in the example of FIG. 2). The second wiring layer 213 is laminated on the other surface of the substrate layer 211 (the surface opposite to the first wiring layer 212; the lower plate surface in the example of FIG. 2). In the example of FIG. 2, the second wiring layer 213 is laminated on the substrate layer 211 via the heat flow sensor 29A.

The first wiring layer 212 and the second wiring layer 213 are each made of a conductor such as metal, and form a wiring pattern on the circuit board 21. The first wiring layer 212 and the second wiring layer 213 may have a portion electrically connected to each other, for example, by a via hole penetrating the substrate layer 211.

### <Base 22>

The base 22 is one example of an auxiliary member that supports the circuit board 21. The base 22 supports the circuit board 21 from below. The base 22 is made of a conductor (for example, copper) and may have a function of electrically connecting the second wiring layer 213 of the circuit board 21 to an external circuit of the semiconductor module 2. Furthermore, the base 22 may be a lead frame or may be an insulating substrate.

### <Bonding Layer 23>

The bonding layer 23 bonds the second wiring layer 213 of the circuit board 21 to the base 22. The bonding layer 23 is made of a bonding material having conductivity, such as solder.

### <Semiconductor Device 24>

The semiconductor device 24 is fixed to the surface of the first wiring layer 212 of the circuit board 21. The semiconductor device 24 includes a device main body 241 and an adhesive layer 242.

The type of the device main body 241 is not particularly limited, and examples thereof include chip devices such as diodes, transistors, thyristors, and integrated circuits. On the other hand, when the device main body 241 is a power semiconductor device, such as a semiconductor device for electric power applications using SiC, GaN, or the like, the amount of heat generation of the device main body 241 is large, and therefore the predictive effect of the occurrence of abnormalities in the semiconductor module 2 by the abnormality determination system 1 becomes remarkable.

The adhesive layer 242 bonds the device main body 241 to the first wiring layer 212. The adhesive layer 242 is configured by a die bond, such as an adhesive having conductivity or solder. In the example of FIG. 2, the device main body 241 is electrically connected to the first wiring layer 212 by the adhesive layer 242, and may also be electrically connected to the first wiring layer 212 by the bonding wires 27.

### <First Terminal 25A and Second Terminal 25B>

The first terminal 25A and the second terminal 25B are respective contact points for electrically connecting the semiconductor module 2 to an external power supply, circuit, or the like. For example, input power is applied to the semiconductor module 2 via the first terminal 25A and the second terminal 25B. he first terminal 25A and the second terminal 25B are each electrically connected to the first wiring layer 212 of the circuit board 21 by the bonding wires 27.

### <Frame Body 26A and Sealing Material 26B>

The frame body 26A and the sealing material 26B are one example of auxiliary members that surround the circuit board 21. The frame body 26A is a cylindrical casing in which the circuit board 21 and at least a part of the base 22 are disposed inside. The frame body 26A is made of an insulating material such as an insulating resin. The first terminal 25A and the second terminal 25B are attached to the frame body 26A so that their end portions protrude from the frame body 26A. In addition, the base 22 seals the bottom of the frame body 26A. That is, an upper surface of the base 22 constitutes a bottom surface of an internal space of the frame body 26A.

The sealing material 26B is filled into the internal space of the frame body 26A. The sealing material 26B is made of an insulating material such as an insulating resin. The sealing material 26B covers the circuit board 21 and the semiconductor device 24 inside the frame body 26A.

### <Bonding Wire 27>

Each of the bonding wires 27 is a metallic wire that electrically connects wirings, devices, and the like. In the example of FIG. 2, the bonding wires 27 electrically connect the device main body 241, the first terminal 25A, and the second terminal 25B to the first wiring layer 212.

### <Heat Flow Sensor 29A>

The heat flow sensor 29A is disposed at a position where heat flow associated with heat generation of the semiconductor device 24 in the semiconductor module 2 occurs. Here, the "position where heat flow ... occurs" includes any position that is physically connected to the semiconductor device 24, either directly or via other members (such as the circuit board 21, the base 22, the bonding layer 23, the first terminal 25A, the second terminal 25B, the frame body 26A, the sealing material 26B, the bonding wires 27, etc.) (where a heat-flow path is formed without any intervening air layer). In other words, the "position where heat flow ... occurs" includes any position in the semiconductor module 2 that is not isolated from the semiconductor device 24 by a heat insulating material (including an air layer). As the "position where heat flow ... occurs" at which the heat flow sensor 29A is disposed, a plate surface (interface) to which another member is bonded is particularly preferable in a layered or plate-like member.

In the example of FIG. 2, the heat flow sensor 29A is disposed on the surface of the substrate layer 211 (or on the surface of the second wiring layer 213) of the circuit board 21. With such a configuration, the heat flow sensor 29A can be formed on the substrate layer 211 or the second wiring layer 213 of the circuit board 21, thereby facilitating manufacture of the semiconductor module 2. More specifically, the heat flow sensor 29A is disposed between the substrate layer 211 and the second wiring layer 213. With such a configuration, the heat flow sensor 29A can be formed inside the circuit board 21 on which the semiconductor device 24 is mounted, thereby improving the accuracy of heat-flow detection. Specifically, the heat flow from the semiconductor device 24 toward the base 22 can be monitored by the heat flow sensor 29A. Thus, when delamination occurs in the bonding layer 23, heat accumulation in the circuit board 21 can be detected and an abnormality can be detected.

The thickness direction of the heat flow sensor 29A is parallel to the thickness direction of the substrate layer 211 (the thickness direction of the circuit board 21). Therefore, the thickness direction of the heat flow sensor 29A is more likely to coincide with the direction of the heat flow between the substrate layer 211 and the second wiring layer 213, thereby improving the sensitivity of the heat flow sensor 29A. A temperature sensor may also be incorporated into the heat flow sensor 29A. That is, the heat flow sensor 29A may be configured to output both the heat flow and the temperature of the semiconductor module 2.

The heat flow sensor 29A is a thin-film sensor configured to detect heat flow that occurs between the substrate layer 211 and the second wiring layer 213. The heat flow sensor 29A may be bonded to the substrate layer 211 or the second wiring layer 213 by ultrasonic waves or the like, or may be directly formed on the substrate layer 211 by a deposition technique. The output of the heat flow sensor 29A may be extracted via the circuit board 21, or may be extracted by a circuit or wiring independent of the circuit board 21.

The heat flow measured by the heat flow sensor 29A is typically caused by heat generated from the measurement object (the member to which the heat flow sensor 29A is attached). Specifically, the heat flow sensor 29A measures heat flow by converting a thermal gradient (temperature gradient) caused by heat exchange with the measurement object or with the surrounding environment into electric power. Here, the "heat exchange" refers to the inflow of heat from the measurement object or the surrounding environment into the heat flow sensor 29A, and the outflow of heat from the heat flow sensor 29A to the measurement object or the surrounding environment. The heat flow sensor 29A is configured to output a thermoelectromotive force in accordance with the thermal gradient.

As the heat flow sensor 29A, for example, it is possible to use a Seebeck-type heat flow sensor utilizing the Seebeck effect, or an anomalous Nernst-type heat flow sensor utilizing the anomalous Nernst effect. To enhance thermal responsiveness, the thickness of the Seebeck-type heat flow sensor is preferably, for example, less than 250 micrometers, more preferably less than 100 micrometers, still more preferably less than 10 micrometers, and even more preferably less than one micrometer. The thickness of the anomalous Nernst-type heat flow sensor is preferably, for example, less than one micrometer.

As the heat flow sensor 29A, a thin-film type heat flow sensor based on a transverse thermoelectric effect such as the anomalous Nernst effect or the spin Seebeck effect is preferable. The heat flow sensor 29A may also be configured to detect a thermal gradient by utilizing both the Seebeck effect and the anomalous Nernst effect.

In particular, the heat flow sensor 29A preferably includes a thermoelectric conversion unit configured, on the basis of the anomalous Nernst effect, to convert a thermal gradient generated through heat exchange with the measurement object (the member to which the heat flow sensor 29A is attached) into an electric signal. That is, it is preferable that the heat flow sensor 29A be an anomalous Nernst-type heat flow sensor. With such a configuration, the sensitivity and time response of the heat flow sensor can be enhanced compared to when the Seebeck effect is utilized. In addition, the use of an anomalous Nernst-type heat flow sensor can facilitate thinning of the heat flow sensor, thereby reducing the thermal resistance and heat capacity.

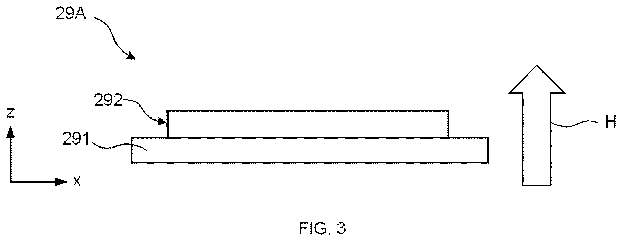

FIG. 3 is a schematic side view of the heat flow sensor 29A utilizing the anomalous Nernst effect. The heat flow sensor 29A includes an insulation part 291 and a thermoelectric conversion unit 292.

### <Insulation Part 291>

The insulation part 291 is a layered member having insulating properties. As the material of the insulation part 291, a semiconductor or an insulator made of, for example, resin or ceramic is used. It is preferable that the material of the insulation part 291 has high thermal conductivity. For example, the insulation part 291 preferably has a higher thermal conductivity than a substrate 2920 of the thermoelectric conversion unit 292 described later. The shape of the insulation part 291 is arbitrary. The insulation part 291 may be curved or bent and may be a deformable so-called flexible substrate.

On one surface (plate surface) of the insulation part 291, the thermoelectric conversion unit 292 is disposed (bonded). The heat flow sensor 29A is arranged such that the thickness direction of the insulation part 291 substantially coincides with the direction of the heat flow H. As a result, the thermal gradient in the thermoelectric conversion unit 292 increases, thereby improving the sensitivity of the thermoelectric conversion unit 292.

### <Thermoelectric Conversion Unit 292>

The thermoelectric conversion unit 292 is configured, on the basis of the anomalous Nernst effect, to convert a thermal gradient generated through heat exchange with the measurement subject into an electric signal. The thermoelectric conversion unit 292 is a layered member (for example, having a substrate shape) laminated on the insulation part 291.

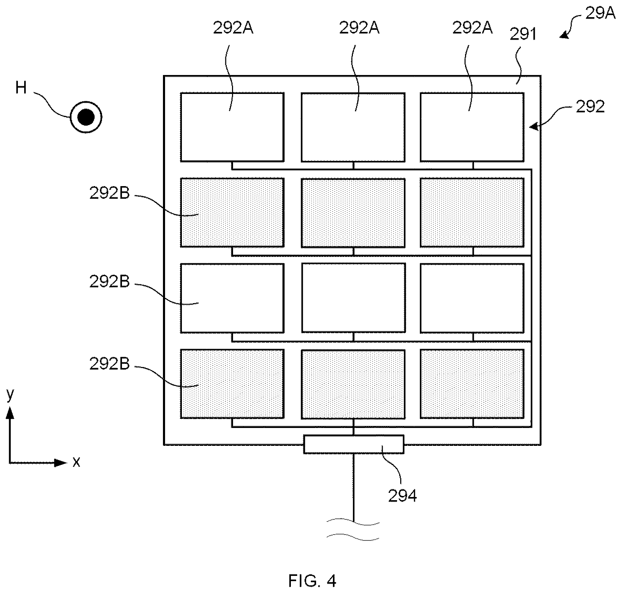

FIG. 4 is a schematic plan view of the thermoelectric conversion unit 292. The thermoelectric conversion unit 292 includes a plurality of first thermoelectric conversion devices 292A and a plurality of second thermoelectric conversion devices 292B. The second thermoelectric conversion devices 292B are configured so that, for a thermal gradient in substantially the same direction as the thermal gradient of the first thermoelectric conversion devices 292A, the sign of only one of a first electromotive force V1 and a second electromotive force V2 described below is opposite to that of the first thermoelectric conversion devices 292A (that is, the positive and negative signs are inverted).

The thermal gradient in the first thermoelectric conversion devices 292A and the second thermoelectric conversion devices 292B includes at least a vertical component that is along the thickness direction of the insulation part 291 (i.e., orthogonal to the surface of the insulation part 291 on which the thermoelectric conversion unit 292 is disposed). When the surface of the insulation part 291 is curved, the direction of the vertical component of the thermal gradient can be defined by a local normal direction of the surface of the insulation part 291. Accordingly, the direction of the vertical component of the thermal gradient is not necessarily uniform over the entire area of the insulation part 291.

Further, the thermal gradient may include an in-plane component that is orthogonal to the vertical component (that is, parallel to the surface of the insulation part 291 on which the thermoelectric conversion unit 292 is disposed). The in-plane component of the thermal gradient can be caused due to variations in heat or thermal conduction in the in-plane direction of the insulation part 291. When the surface of the insulation part 291 is curved, the direction of the in-plane component of the thermal gradient can be defined by a direction orthogonal to the local normal of the surface of the insulation part 291. Accordingly, the direction of the in-plane component of the thermal gradient is not necessarily uniform over the entire area of the insulation part 291.

Note that being "orthogonal" to a certain direction or plane is not limited to being perfectly orthogonal thereto, but may also include being orthogonal within the range of allowable error in dimensions and the like. Similarly, being "parallel" to a certain direction or plane is not limited to being perfectly parallel thereto.

The thermoelectromotive force V output by the first thermoelectric conversion device 292A and the second thermoelectric conversion device 292B can include a first electromotive force V1 and a second electromotive force V2. The first electromotive force V1 is a thermoelectromotive force due to a first thermoelectric conversion effect based on the vertical component of the thermal gradient. The first thermoelectric conversion effect has an expression mechanism different from the Seebeck effect and is exhibited by the anomalous Nernst effect.

The first electromotive force V1 is expressed, for example, by a quantity that depends on a physical variable corresponding to a magnetic field among the off-diagonal components of the thermoelectric tensors of the first thermoelectric conversion devices 292A and the second thermoelectric conversion devices 292B. The first electromotive force V1 is antisymmetric with respect to the magnetic field, symmetric with respect to the in-plane component of the thermal gradient, and antisymmetric with respect to the vertical component of the thermal gradient. Further, the direction of the first electromotive force V1 is substantially orthogonal to the vertical component of the thermal gradient.

The second electromotive force V2 is a thermoelectromotive force due to a second thermoelectric conversion effect based on the in-plane component of the thermal gradient. The second thermoelectric conversion effect has an expression mechanism different from the first thermoelectric conversion effect and is exhibited by diagonal components of a thermoelectric tensor, such as the Seebeck effect. The second electromotive force V2 is expressed, for example, by a quantity that depends on a physical variable corresponding to the thermal gradient among the diagonal components of the thermoelectric tensors of the first thermoelectric conversion devices 292A and the second thermoelectric conversion devices 292B. The second electromotive force V2 is a quantity that is antisymmetric with respect to the thermal gradient. The direction of the second electromotive force V2 is substantially parallel to the direction of the in-plane component of the thermal gradient. Accordingly, when the in-plane component of the thermal gradient is parallel to the direction of the first electromotive force V1, the direction of the second electromotive force V2 becomes substantially parallel to the direction of the first electromotive force V1.

As shown in FIG. 4, the plurality of first thermoelectric conversion devices 292A and the plurality of second thermoelectric conversion devices 292B are each disposed on the same surface of one insulation part 291. In the example of FIG. 4, the plurality of first thermoelectric conversion devices 292A and the plurality of second thermoelectric conversion devices 292B are arranged side by side in the x-direction, while the first thermoelectric conversion devices 292A and the second thermoelectric conversion devices 292B are alternately arranged in the y-direction. As a result, for example, measurement errors caused by fluctuations in the in-plane component of the thermal gradient on the surface of the insulation part 291 can be reduced. Further, the plurality of first thermoelectric conversion devices 292A and the plurality of second thermoelectric conversion devices 292B are connected in parallel by wiring.

The arrangement aspect of the first thermoelectric conversion devices 292A and the second thermoelectric conversion devices 292B is arbitrary. For example, the first thermoelectric conversion devices 292A and the second thermoelectric conversion devices 292B may be arranged on different insulation parts 291. Furthermore, the first thermoelectric conversion devices 292A and the second thermoelectric conversion devices 292B may be electrically insulated from each other. This makes it possible to suppress fluctuations of the thermoelectromotive force V output from each thermoelectric conversion device due to noise. Furthermore, the plurality of first thermoelectric conversion devices 292A may be connected in series with each other. The plurality of second thermoelectric conversion devices 292B may also be connected in series. This enables amplification of the magnitudes of the first electromotive force V1 and the second electromotive force V2 included in the thermoelectromotive force V of the plurality of thermoelectric conversion devices connected in series. Moreover, the first thermoelectric conversion devices 292A and the second thermoelectric conversion devices 292B may also be connected in series.

In this embodiment, it is not necessarily required to use both the first thermoelectric conversion devices 292A and the second thermoelectric conversion devices 292B. That is, the thermoelectric conversion unit 292 of the heat flow sensor 29A may include only the first thermoelectric conversion devices 292A.

### <First Thermoelectric Conversion Device 292A>

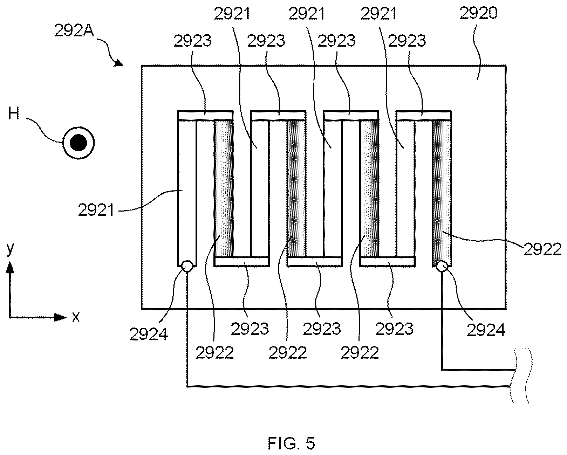

The configuration of the first thermoelectric conversion device 292A will be described below. Note that the configuration of the second thermoelectric conversion device 292B is common to that of the first thermoelectric conversion device 292A except for points described later. FIG. 5 is a schematic plan view of the first thermoelectric conversion device 292A. As shown in FIG. 5, the first thermoelectric conversion device 292A includes a substrate 2920, a plurality of thermoelectric conversion elements 2921, a plurality of first conductors 2922, a plurality of second conductors 2923, and a plurality of measurement terminals 2924.

### <Substrate 2920>

The substrate 2920 is laminated on the surface of the insulation part 291. The planar area of the substrate 2920 is smaller than the planar area of the insulation part 291. The substrate 2920 may be integrally formed with the insulation part 291. As the material of the substrate 2920, for example, a semiconductor or an insulator such as silicon or MgO is used.

### <Thermoelectric Conversion Element 2921>

The thermoelectric conversion element 2921 is configured to exhibit the anomalous Nernst effect. The thermoelectric conversion element 2921 may be made of, for example, a topological ferromagnetic material or a topological antiferromagnetic material, which are called Weyl semimetals, or it may be made of a ferrimagnetic material, or it may be a combination of these. The topological ferromagnetic material may be metal with a Co₂TX composition, such as Co₂MnGa (where X is any one of Si, Ge, Sn, Al, and Ga), or an alloy of a known topological ferromagnetic material, such as metal with a composition formula represented by Fe₃X (where X is a stoichiometric or off-stoichiometric composition that is a typical element or transition element such as Al or Ga). The topological antiferromagnetic material may be a known topological antiferromagnetic material such as Mn₃X (where X is one or more elements selected from Sn, Ge, Ga, Pt, Ir, Rh, or a compound thereof). The compound constituting the thermoelectric conversion element 2921 may be, for example, an alloy containing a transition metal, and the alloy may be a compound having a crystal structure with kagome lattice planes formed by the transition metal, and may exhibit the anomalous Nernst effect.

The composition ratio of the alloy constituting the topological ferromagnetic material or topological antiferromagnetic material is not necessarily limited to the above-mentioned stoichiometric composition ratio, and is not particularly limited as long as it has a partially stoichiometric structure (for example, a DO₃-type crystal structure, a B2-type crystal structure, etc.). The ferrimagnetic material is also not particularly limited, as long as it exhibits the anomalous Nernst effect. The structure of the thermoelectric conversion element 2921 is not particularly limited, and any known structures can be used.

Since the thin-film type thermoelectric conversion element 2921 based on the anomalous Nernst effect is made of an alloy, a heat flow sensor including the thermoelectric conversion element 2921 has lower thermal resistance and thermal capacity compared to a heat flow sensor that generates the Seebeck effect. Therefore, such a heat flow sensor has higher sensitivity and superior time response compared to conventional heat flow sensors that generate the Seebeck effect.

Typically, the thermoelectric conversion element 2921 includes a magnetic material having a magnetic structure capable of exhibiting the anomalous Nernst effect. The magnetic structure may be any of an antiferromagnetic structure, a canted antiferromagnetic structure, a ferrimagnetic structure, a ferromagnetic structure, and a weak ferromagnetic structure (an antiferromagnetic magnetic order having spontaneous magnetization), as long as it can exhibit the anomalous Nernst effect. The magnetic structure of the magnetic material includes at least one of a first magnetic structure and a second magnetic structure configured to be time-reversal symmetric with respect to the first magnetic structure.

As described above, the material of the thermoelectric conversion element 2921 may be arbitrarily selected as long as it includes a substance capable of exhibiting the anomalous Nernst effect. The thermoelectric conversion elements 2921 of the first thermoelectric conversion device 292A and that of the second thermoelectric conversion device 292B are constituted of substantially the same composition capable of exhibiting the anomalous Nernst effect. Examples of compositions capable of exhibiting such an anomalous Nernst effect include Mn₃Sn, Mn₃Ge, Mn₃Ga, Co₂MnGa, Fe₃Al, Fe₃Ga, Fe₂Sn, alloys thereof, element substitutes thereof, and mixtures thereof. The expression mechanism of the anomalous Nernst effect is not limited, and examples include one attributable to an antiferromagnetic magnetic structure having a non-collinear spin structure. In this case, the Nernst coefficient tends to be larger than that of other expression mechanisms, thus facilitating higher-accuracy measurement and miniaturization of the element. The thermoelectric conversion element 2921 may be realized as a polycrystalline body or as a single-crystal body of these materials. The crystallographic domains of the single-crystal body may be sufficiently uniform to the extent that asymmetrical physical properties due to a reduction in symmetry associated with the emergence of magnetic order can be observed.

In this embodiment, the thermoelectric conversion element 2921 is formed as a thin film having a thickness in a direction perpendicular to the surface of the substrate 2920. The easy axis of magnetization and the spin easy axis of the thermoelectric conversion element 2921 tend to extend in a direction along the surface of the substrate 2920 because the contribution of magnetic anisotropy due to thinning becomes greater than other factors. This makes it easier to appropriately adjust the direction of the first electromotive force V1 generated by the anomalous Nernst effect. The thickness of the thermoelectric conversion element 2921 is arbitrary; specifically, for example, it may be 5, 6, 7, 8, 9, 10, 20, 30, 40, 50, 60, 70, 80, 90, 100, 200, 300, 400, 500, 600, 700, 800, or 900 nm, may be within a range between any two of the numerical values exemplified here, or may also be outside these ranges. The method of implementing the thermoelectric conversion element 2921 on the substrate 2920 is not limited, and any method may be employed, including physical vapor deposition such as sputtering and ion plating, plating method, chemical vapor deposition, molecular beam epitaxial growth (MBE), sintering of powder of the compound that forms the thermoelectric conversion element 2921, various printing methods such as inkjet printing using droplets in which the compound is dissolved, three-dimensional printing using the compound, and pasting. The implementing method of the thermoelectric conversion element 2921 may be the same type of method as that for implementing the first conductor 2922 and the second conductor 2923. This makes it possible to simplify the step during manufacture of the heat flow sensor 29A. The thermoelectric conversion elements 2921 included in one first thermoelectric conversion device 292A may include the same magnetic material or may include different magnetic materials.

The thermoelectric conversion element 2921 extends linearly along a direction in which the first electromotive force V1 is generated (the y-direction in the example of FIG. 5) in a plan view. That is, the thermoelectric conversion element 2921 is formed on the substrate 2920 in a strip shape having a longitudinal direction parallel to the direction in which the first electromotive force V1 is generated. The direction in which the first electromotive force V1 is generated is the direction in which the anomalous Nernst effect due to the vertical component of the thermal gradient is maximized. Note that the central axis (longitudinal direction) of the thermoelectric conversion element 2921 in a plan view may be curved or bent.

The first thermoelectric conversion devices 292A and the second thermoelectric conversion devices 292B are arranged such that the longitudinal directions of their respective thermoelectric conversion elements 2921 are parallel to each other. This reduces the deviation of the first electromotive force V1 generated in the first thermoelectric conversion devices 292A and the second thermoelectric conversion devices 292B due to the anomalous Nernst effect caused by the vertical component of the thermal gradient, making it easier to separate the contribution of the first electromotive force V1 and the contribution of the second electromotive force V2 included in the thermoelectromotive force V.

The number of thermoelectric conversion elements 2921 included in the first thermoelectric conversion device 292A and in the second thermoelectric conversion device 292B is arbitrary. The number of thermoelectric conversion elements 2921 included in the first thermoelectric conversion device 292A may be the same as or different from the number of thermoelectric conversion elements 2921 included in the second thermoelectric conversion device 292B. The number of thermoelectric conversion elements 2921 included in the first thermoelectric conversion device 292A and the number of thermoelectric conversion elements 2921 included in the second thermoelectric conversion device 292B are each selected so that the deviation between the second electromotive force V2 generated from one entire first thermoelectric conversion device 292A and the second electromotive force V2 generated from one entire second thermoelectric conversion device 292B becomes small compared to the required measurement accuracy.

The sign of the Nernst coefficient of the thermoelectric conversion element 2921 in the first thermoelectric conversion device 292A is different from that of the thermoelectric conversion element 2921 in the second thermoelectric conversion device 292B. In other words, the polarity of the thermoelectric conversion element 2921 in the first thermoelectric conversion device 292A differs from the polarity of the thermoelectric conversion element 2921 in the second thermoelectric conversion device 292B. Thus, the sign of the first electromotive force V1 of the thermoelectric conversion element 2921 in the first thermoelectric conversion device 292A generated by a given thermal gradient is different (i.e., inverted in sign) from the sign of the first electromotive force V1 of the thermoelectric conversion element 2921 in the second thermoelectric conversion device 292B generated by the same thermal gradient. Meanwhile, the second electromotive force V2 of the thermoelectric conversion element 2921 in the second thermoelectric conversion device 292B generated by the thermal gradient and the second electromotive force V2 of the thermoelectric conversion element 2921 in the second thermoelectric conversion device 292B have the same sign, because they are defined by the direction of the in-plane component of the thermal gradient. Such inversion of polarity regarding the anomalous Nernst effect between the first thermoelectric conversion device 292A and the second thermoelectric conversion device 292B can be realized, for example, by inverting the polarity of the magnetic structure (e.g., the direction of spontaneous magnetization) of the magnetic material contained in the thermoelectric conversion element 2921, or by inverting the sign of the material-specific Nernst coefficient included in the thermoelectric conversion element 2921.

The magnetic material of the thermoelectric conversion element 2921 in the first thermoelectric conversion device 292A is configured so that the ratio of the magnetic domains corresponding to the second magnetic structure to the magnetic domains corresponding to the first magnetic structure is greater than one. The magnetic material of the thermoelectric conversion element 2921 in the second thermoelectric conversion device 292B is configured so that the ratio of the magnetic domains corresponding to the second magnetic structure to the magnetic domains corresponding to the first magnetic structure is less than one. In other words, in the respective thermoelectric conversion elements 2921 in the first thermoelectric conversion device 292A and the second thermoelectric conversion device 292B, the sign of the component of the thermoelectric tensor corresponding to the anomalous Nernst effect caused by the first magnetic structure differs from the sign of the component of the thermoelectric tensor corresponding to the anomalous Nernst effect caused by the second magnetic structure. As a result, the thermoelectric conversion element 2921 in the second thermoelectric conversion device 292B is configured so that the sign of the first electromotive force V1 is opposite to the thermal gradient in the substantially same direction as the thermal gradient of the thermoelectric conversion element 2921 in the first thermoelectric conversion device 292A. In such a magnetic structure, spontaneous magnetization occurs along the easy axis of magnetization. When the magnetic material is a ferromagnet or a ferrimagnet, the easy axis of magnetization is substantially parallel to the spin easy axis. On the other hand, when the magnetic material is a canted antiferromagnet, the easy axis of magnetization intersects the spin easy axis (for example, is orthogonal to the easy axis). The magnetic structure of the first thermoelectric conversion device 292A has a polarity different from that of the magnetic structure of the second thermoelectric conversion device 292B. Therefore, the orientation of the magnetic domains of the first thermoelectric conversion device 292A is inverted relative to the orientation of the magnetic domains of the second thermoelectric conversion device 292B. In the present embodiment, the thermoelectric conversion element 2921 includes a ferrimagnet, and its easy axis of magnetization intersects the longitudinal direction of the thermoelectric conversion element 2921 and is parallel to the surface of the insulation part 291.

### <First Conductor 2922 and Second Conductor 2923>

The first conductors 2922 and the second conductors 2923 connect the thermoelectric conversion elements 2921 in series so as to amplify the first electromotive force V1 of the thermoelectric conversion elements 2921.

Each first conductor 2922 extends linearly along the longitudinal direction of the thermoelectric conversion element 2921 in a plan view. That is, the first conductor 2922 is formed on the substrate 2920 in a strip shape having a longitudinal direction parallel to the longitudinal direction of the thermoelectric conversion element 2921. The first conductor 2922 is disposed between two thermoelectric conversion elements 2921 in the width direction of the thermoelectric conversion element 2921.

Each second conductor 2923 electrically connects an end of one thermoelectric conversion element 2921 and an end of the first conductor 2922 adjacent to this thermoelectric conversion element 2921. The second conductor 2923 extends linearly along the width direction of the thermoelectric conversion element 2921 in a plan view. That is, the second conductor 2923 is formed on the substrate 2920 in a strip shape having a longitudinal direction parallel to the width direction of the thermoelectric conversion element 2921.

The first conductor 2922 and the second conductor 2923 form a meander structure in the first thermoelectric conversion device 292A, in which the thermoelectric conversion elements 2921 and the first conductors 2922 are alternately arranged. Note that the connection aspect among the thermoelectric conversion element 2921, the first conductor 2922, and the second conductor 2923 is arbitrary. Furthermore, a method for forming the first conductor 2922 and the second conductor 2923 is also arbitrary. For example, the first conductor 2922 and the second conductor 2923 may be formed by metal sputtering to the substrate 2920, or may be connected to the thermoelectric conversion element 2921 by leads after being laminated on the substrate 2920.

### <Measurement Terminal 2924>

The measurement terminal 2924 constitute a terminal of an electric circuit including the thermoelectric conversion elements 2921 formed in the first thermoelectric conversion device 292A. In the example of FIG. 5, one measurement terminal 2924 is electrically connected to an end of the thermoelectric conversion element 2921, and the other measurement terminal 2924 is electrically connected to an end of the first conductor 2922. The measurement terminal 2924 may be a physical connection terminal such as a pin, a tab, or a ribbon terminal, or may be a virtual terminal serving as a measurement point of the thermoelectromotive force V. By means of the two measurement terminals 2924, the thermoelectromotive force V output from the plurality of thermoelectric conversion elements 2921 connected in series by the first conductors 2922 and the second conductors 2923 is acquired. The measurement terminals 2924 of one first thermoelectric conversion device 292A are electrically insulated from the measurement terminals 2924 of another first thermoelectric conversion device 292A or a second thermoelectric conversion device 292B. This reduces the contact resistance of the first thermoelectric conversion device 292A, thereby improving the measurement accuracy of the thermoelectromotive force V.

### <Port 294>

As shown in FIG. 4, the heat flow sensor 29A further includes a port 294. The port 294 is configured to electrically connect the plurality of first thermoelectric conversion devices 292A and second thermoelectric conversion devices 292B to an external device (the electric power measuring device 3).

In the example of FIG. 4, the port 294 is electrically connected to the respective measurement terminals 2924 of the plurality of first thermoelectric conversion devices 292A and the plurality of second thermoelectric conversion devices 292B. Any wiring may be interposed between each measurement terminal 2924 and the port 294. By connecting the port 294 to an external device such as the electric power measuring device 3, signals relating to the thermoelectromotive force V output from each of the plurality of first thermoelectric conversion devices 292A and the plurality of second thermoelectric conversion devices 292B (specifically, from their measurement terminals 2924) are transmitted to the external device. The external device can execute various processing based on the signals output from the heat flow sensor 29A.

In the example of FIG. 4, the port 294 is configured to encompass the wiring extending from each of the plurality of measurement terminals 2924. This makes it easier to simplify the wiring when connecting to an external device. For example, the port 294 may be a multi-channel port capable of transmitting, as independent signals, the thermoelectromotive force V output from each measurement terminal 2924.

In the thermoelectric conversion unit 292, when the thermoelectromotive force V of the first thermoelectric conversion device 292A for a given thermal gradient is V = +V1 + V2, the thermoelectromotive force V of the second thermoelectric conversion device 292B for the same thermal gradient becomes V = -V1 + V2. That is, the direction of the first electromotive force V1 caused by the anomalous Nernst effect is inverted. Accordingly, by comparing the thermoelectromotive force V of the first thermoelectric conversion device 292A with the thermoelectromotive force V of the second thermoelectric conversion device 292B, it is possible to more accurately separate the components of the thermoelectromotive force V caused by the thermal gradient, such as the first electromotive force V1 and the second electromotive force V2.

### <Arrangement Pattern of Heat Flow Sensor>

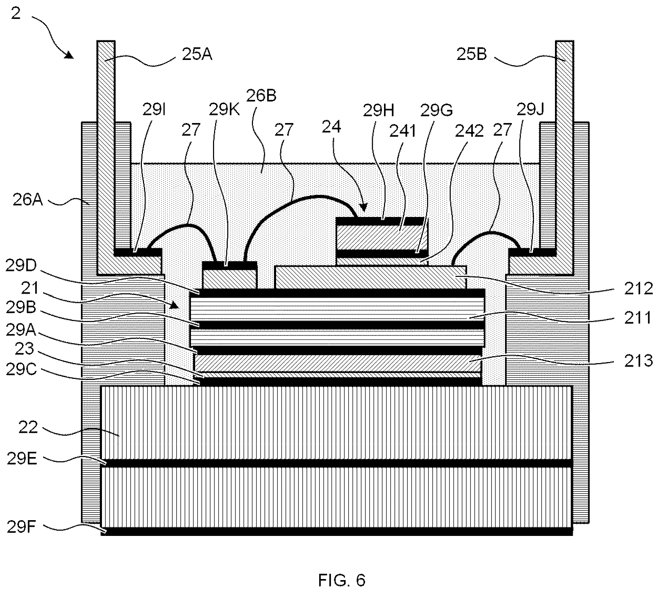

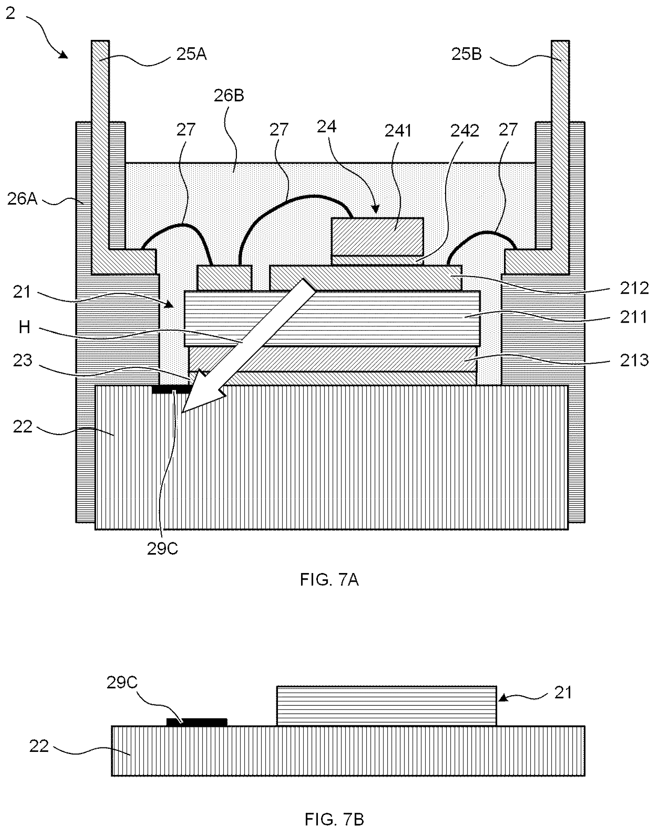

The position of the heat flow sensor in the semiconductor module 2 is not limited to the example shown in FIG. 2. FIGS. 6, 7A and 7B are schematic cross-sectional views showing arrangement patterns of the heat flow sensor in the semiconductor module 2. The components of the semiconductor module 2 in FIGS. 6, 7A and 7B are the same as those of the semiconductor module 2 in FIG. 2. In addition, the heat flow sensor 29A in FIG. 6 is the same as the heat flow sensor 29A in FIG. 2.

Although FIG. 6 shows a plurality of heat flow sensors 29A to 29K, the semiconductor module 2 only needs to include at least one of these heat flow sensors. When a plurality of heat flow sensors are used, a Seebeck-type heat flow sensor and an anomalous Nernst-type heat flow sensor may be combined. A heat flow sensor disposed at an interface between members may be disposed over the entire interface or over a part of the interface.

In FIG. 6, the heat flow sensor 29B is disposed in a layered manner inside the substrate layer 211. The thickness direction of the heat flow sensor 29B is parallel to the thickness direction of the substrate layer 211. For example, the heat flow sensor 29B is sandwiched between two layers constituting the substrate layer 211.

The heat flow sensor 29C in FIG. 6 is disposed between the base 22 and the bonding layer 23. That is, the heat flow sensor 29C is disposed in an area that overlaps the circuit board 21 on the outer surface of the base 22 to which the circuit board 21 is bonded. With such a configuration, the heat flow sensor 29C can be installed after assembling the circuit board 21 onto the auxiliary member (the base 22), and thus the manufacture of the semiconductor module 2 is facilitated. In addition, the thickness direction of the heat flow sensor 29C is parallel to the thickness direction of the bonding layer 23.

As shown in FIG. 7A, the heat flow sensor 29C may be disposed on the outer surface of the base 22 at a position that includes an area that does not overlap with the circuit board 21 (that is, a position where the direction of the heat flow H from the circuit board 21 to the base 22 intersects the thickness direction of the heat flow sensor 29C). Heat flow does not necessarily flow only in the thickness direction of the circuit board 21. Thus, when the heat flow sensor 29C is configured to detect a thermal gradient by generating the Seebeck effect in an in-plane direction, or when the heat flow sensor 29C includes a thermoelectric conversion unit 292 configured to output a thermoelectromotive force based on the thermal gradient in the in-plane direction, heat flow can be detected by disposing the heat flow sensor 29C at such a position. Furthermore, as shown in FIG. 7B, the heat flow sensor 29C may be disposed at a position away from the circuit board 21 on the outer surface of the base 22 (including a lead frame and an insulating substrate) to which the circuit board 21 is bonded, as long as the position is a position where the heat flow occurs due to heat dissipation from the base 22.

The heat flow sensor 29D in FIG. 6 is disposed on the surface of the substrate layer 211 of the circuit board 21 (or on the surface of the first wiring layer 212). More specifically, the heat flow sensor 29D is disposed between the substrate layer 211 and the first wiring layer 212. The thickness direction of the heat flow sensor 29D is parallel to the thickness direction of the substrate layer 211 (the thickness direction of the circuit board 21).

The heat flow sensor 29E in FIG. 6 is disposed in a layered manner inside the base 22. The thickness direction of the heat flow sensor 29E is parallel to the thickness direction of the base 22. For example, the heat flow sensor 29E is sandwiched between two layers constituting the base 22.

The heat flow sensor 29F in FIG. 6 is disposed on the outer surface of the base 22 opposite to the outer surface to which the circuit board 21 is bonded, and constitutes the outermost surface of the semiconductor module 2. The thickness direction of the heat flow sensor 29F is parallel to the thickness direction of the base 22.

The heat flow sensor 29G in FIG. 6 is disposed between the device main body 241 of the semiconductor device 24 and the adhesive layer 242. Specifically, the heat flow sensor 29G is disposed on the surface of the adhesive layer 242 opposite to the first wiring layer 212. The thickness direction of the heat flow sensor 29G is parallel to the thickness direction of the circuit board 21.

The heat flow sensor 29H in FIG. 6 is disposed on the outer surface of the semiconductor device 24. With such a configuration, the heat flow sensor can be installed after the semiconductor device 24 is mounted on the circuit board 21, and thus the manufacture of the semiconductor module 2 is facilitated. Specifically, the heat flow sensor 29H is disposed on the upper surface of the device main body 241 of the semiconductor device 24, which is not covered by the adhesive layer 242. The thickness direction of the heat flow sensor 29H is parallel to the thickness direction of the circuit board 21.

The heat flow sensor 29I in FIG. 6 is disposed on the surface of the first terminal 25A (specifically, on the connection surface of the bonding wire 27). In addition, the heat flow sensor 29J in FIG. 6 is disposed on the surface of the second terminal 25B (specifically, on the connection surface of the bonding wire 27). In FIG. 6, the thickness directions of the heat flow sensor 29I and the heat flow sensor 29J are parallel to the thickness direction of the circuit board 21. However, the orientations of the heat flow sensor 29I and the heat flow sensor 29J are not limited thereto.

The heat flow sensor 29K in FIG. 6 is disposed on a surface of the first wiring layer 212 of the circuit board 21 (the plate surface opposite to the substrate layer 211). The thickness direction of the heat flow sensor 29K is parallel to the thickness direction of the first wiring layer 212 (the thickness direction of the circuit board 21). Note that the semiconductor device 24 is not disposed on the surface of the heat flow sensor 29K opposite to the first wiring layer 212.

As described above, in FIG. 6, the heat flow sensors are disposed so that their thickness directions coincide with the direction of heat flow in the semiconductor module 2. However, when a heat flow sensor includes a thermoelectric conversion unit 292 configured to output a thermoelectromotive force based on the thermal gradient in the in-plane direction, the heat flow sensor may be disposed at a position where its thickness direction intersects the direction of heat flow in the semiconductor module 2. In addition, in the semiconductor module 2, a heat exhaust path may be designed, and the heat flow sensor may be disposed within this heat exhaust path.

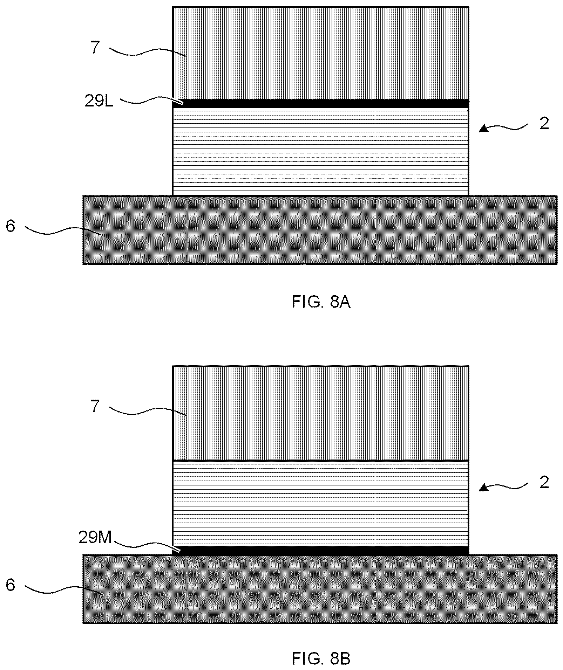

FIG. 8A and FIG. 8B are schematic cross-sectional views showing other examples of the arrangement pattern of the heat flow sensor in the semiconductor module 2. In FIGS. 8A and 8B, the semiconductor module 2 is connected to a printed circuit board 6 and a heat sink 7. The heat flow sensor 29L in FIG. 8A constitutes a part of the outer surface of the semiconductor module 2 that is connected to the heat sink 7, and is bonded to the heat sink 7 and the semiconductor module 2 (for example, the semiconductor device 24). The heat flow sensor 29M in FIG. 8B constitutes a part of the outer surface of the semiconductor module 2 that is connected to the printed circuit board 6, and is bonded to the printed circuit board 6. In this manner, the heat flow sensor may be provided at a connecting portion between the semiconductor module 2 and an external member. That is, the heat flow sensor may constitute a bonding surface of the semiconductor module 2 with an external member.

### <Electric Power Measuring Device 3>

The electric power measuring device 3 is an information processing apparatus or a circuit board configured to convert a thermoelectromotive force V output from the heat flow sensor into information that can be acquired by the information processing apparatus 4 (acquisition unit 431).

### 2. IIardware configuration of information processing apparatus 4

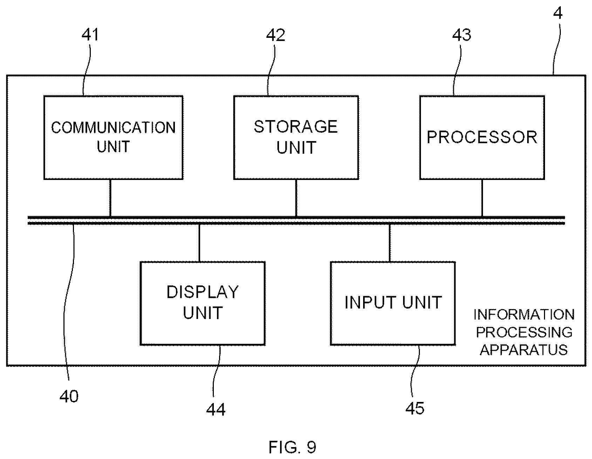

This section describes an example of a hardware configuration of the information processing apparatus 4 described above. FIG. 9 is a block diagram showing a hardware configuration of the information processing apparatus 4. The information processing apparatus 4 includes a communication bus 40, a communication unit 41, a storage unit 42, a processor 43 as a controller, a display unit 44, and an input unit 45. These components are electrically connected via the communication bus 40 inside the information processing apparatus 4.

### <Communication Unit 41>

It is preferable for the communication unit 41 to include wired communication means such as USB, IEEE 1394, Thunderbolt (registered trademark), and wired LAN network communication. The communication unit 41 may also include wireless LAN network communication, mobile communication such as 3G/LTE/5G, and BLUETOOTH (registered trademark) communication as necessary. That is, it is more preferable to implement the communication unit 41 as a set of these multiple types of communication means. In other words, the information processing apparatus 4 may communicate various types of information with an external device via the communication unit 41 and a network.

### <Storage Unit 42>

The storage unit 42 stores the above-defined various kinds of information. The storage unit 42 may be implemented, for example, as a storage device such as a solid state drive (SSD) storing various programs, etc. pertaining to the information processing apparatus 4 and executed by the processor 43, or as a memory such as a random access memory (RAM) storing temporarily necessary information (arguments, arrays, or the like) pertaining to program operations. The storage unit 42 stores various programs, variables, etc. pertaining to the information processing apparatus 4 and executed by the processor 43.

### <Processor 43>

The processor 43 processes and controls overall operation pertaining to the information processing apparatus 4. The processor 43 is, for example, an unshown central processing unit (CPU). The processor 43 implements various functions pertaining to the information processing apparatus 4 by reading a predetermined program stored in the storage unit 42. In other words, information processing by software stored in the storage unit 42 can be executed as each function execution unit included in the processor 43 by specifically realized through the processor 43, that is an example of hardware. These will be described in more detail in the next section. The processor 43 is not limited to being a single unit, and may be implemented with multiple processors 43 for the individual functions. Moreover, a combination thereof may also be acceptable.

### <Display Unit 44>

The display unit 44 may be included in a housing of the information processing apparatus 4, or may be attached thereto externally. The display unit 44 displays a screen of a graphical user interface (GUI) that can be operated by a user. For example, this displaying is preferably implemented by using different display devices, such as a CRT display, a liquid crystal display, an organic EL display, or a plasma display, depending on the type of the information processing apparatus 4.

### <Input Unit 45>

The input unit 45 may be included in the housing of the information processing apparatus 4 or may be attached thereto externally. For example, the input unit 45 may be implemented as a touchscreen integrated with the display unit 44. If it is a touchscreen, the user can input operations such as tapping, swiping, and the like. Of course, instead of a touchscreen, switch buttons, a mouse, a keyboard and the like may be adopted. In other words, the input unit 45 receives an operation input performed by the user. This input is transferred as an instruction signal to the processor 43 via the communication bus 40, and the processor 43 may perform predetermined control or computation as needed.

### 3. Functional configuration of information processing apparatus 4

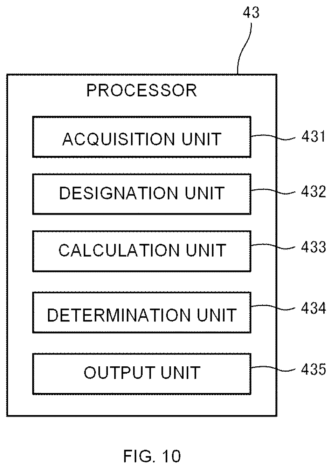

This section describes an example of the functional configuration of the processor 43 described above. FIG. 10 is a diagram illustrating an example of functional units included in the processor 43. The processor 43 includes an acquisition unit 431, a designation unit 432, a calculation unit 433, a determination unit 434, and an output unit 435.

### <Acquisition Unit 431>

The acquisition unit 431 is configured to acquire information output from the electric power measuring device 3. The acquisition unit 431 is, for example, configured to acquire, via the electric power measuring device 3, the respective thermoelectromotive forces V of the first thermoelectric conversion devices 292A and the second thermoelectric conversion devices 292B included in the heat flow sensor 29A.

The acquisition unit 431 preferably acquires the temperature of the semiconductor module 2 and the power supplied to the semiconductor module 2 in addition to the output of the heat flow sensor 29A. The temperature of the semiconductor module 2 is acquired from, for example, a diode, a thermistor, or the like incorporated in the circuit board 21 or the semiconductor device 24 of the semiconductor module 2. Furthermore, the acquisition unit 431 may also acquire the resistance value of the heat flow sensor 29A as an index indirectly indicating the temperature of the semiconductor module 2. The power supplied to the semiconductor module 2 is acquired, for example, from a power supply device.

The acquisition unit 431 is configured to acquire various types of information by: reading out the various types of information stored in a storage area, which is at least a part of the storage unit 42; and writing the readout information into a working area, which is at least a part of the storage unit 42. The storage area is, for example, an area in the storage unit 42, which is implemented as a storage device such as an SSD. The working area is, for example, an area which is implemented as a memory such as RAM.

### <Designation Unit 432>

The designation unit 432 is configured to receive a designation from a user, another functional unit, or another device. For example, the designation unit 432 receives various designations based on an input to the input unit 45.

### <Calculation Unit 433>

The calculation unit 433 is configured to execute various computations based on various kinds of information such as information acquired by the acquisition unit 431, a designation received by the designation unit 432, and the like. For example, the calculation unit 433 calculates the first electromotive force V1 or the second electromotive force V2 based on the thermoelectromotive force V acquired by the acquisition unit 431.

### <Determination Unit 434>

The determination unit 434 is configured to determine an abnormality of the semiconductor module 2 based on the output of the heat flow sensor 29A. With such a configuration, heat retention accompanying interface delamination between members of the semiconductor module 2 can be detected by the heat flow sensor 29A, thereby enabling prediction of the occurrence of abnormalities in the semiconductor module 2, which is less susceptible to influences of the usage environment.

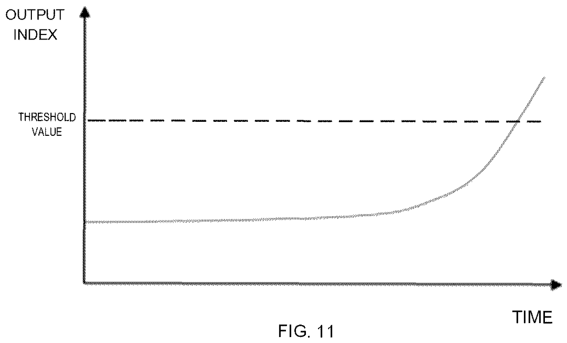

Specifically, when the output (the first electromotive force V1 or the second electromotive force V2) of the heat flow sensor 29A exceeds a predetermined threshold value, the determination unit 434 determines that an abnormality has occurred in the semiconductor module 2. FIG. 11 is a graph illustrating an example of the time variation of the output of the heat flow sensor 29A. In the example of FIG. 11, the determination unit 434 determines the occurrence of an abnormality at the time when the output index of the heat flow sensor 29A exceeds the threshold value.

The threshold value for abnormality determination is designed based on, for example,
an amount of exhaust heat of the semiconductor module 2 obtained by prior measurement, and changes in transient thermal resistance, structure function, and the like. The structure function is a function that represents the relationship between the heat capacity and the thermal resistance of the semiconductor module 2, and changes as cycles are repeated. Thus, the accuracy of abnormality determination can be improved by setting a threshold value based on changes in the structure function. In addition, instead of these indices, the threshold value may be set by further combining the junction temperature of the semiconductor module 2. In this case, the abnormality determination condition (threshold value) of the semiconductor module 2 depends on the usage environment.

The output index used for abnormality determination may be the output (electromotive force) of the heat flow sensor 29A itself, or a normalized value of the output of the heat flow sensor 29A. For example, the output index may be a value obtained by dividing the output of the heat flow sensor 29A by the power supplied to the semiconductor module 2. That is, the determination unit 434 may be configured to determine an abnormality based on the output of the heat flow sensor 29A and the power supplied to the semiconductor module 2. With such a configuration, the output of the heat flow sensor can be normalized based on the supplied power, thereby reducing disturbances. As a result, the accuracy of abnormality determination can be improved.

The determination unit 434 may also be configured to determine an abnormality based on the output of the heat flow sensor 29A and the temperature of the semiconductor module 2. With such a configuration, it becomes possible to determine an abnormality taking into consideration the temperature dependence of the heat capacity, thermal resistance and the like of the heat flow sensor 29A, thereby improving the accuracy of abnormality determination. Specifically, the determination unit 434 may correct the output of the heat flow sensor 29A using the temperature of the semiconductor module 2 (the temperature of the semiconductor module 2 acquired by the acquisition unit 431, or the temperature of the semiconductor module 2 calculated from the resistance value of the heat flow sensor 29A acquired by the acquisition unit 431). The determination unit 434 may also correct the threshold value for determining an abnormality based on the temperature of the semiconductor module 2. Furthermore, in addition to the temperature of the semiconductor module 2, the determination unit 434 may use the ambient temperature of the semiconductor module 2 to correct the output of the heat flow sensor 29A or the threshold value.

The determination unit 434 may input condition parameters such as the output of the heat flow sensor 29A and the temperature of the semiconductor module 2 into an abnormality determination model stored in the storage unit 42, and may cause the abnormality determination model to output the presence or absence of an abnormality in the semiconductor module 2. The abnormality determination model is a trained model learned using training data that combines condition parameters and the presence or absence of an abnormality.

The determination unit 434 may also be configured to determine the lifetime of the semiconductor module 2 (i.e., the predicted time of occurrence of an abnormality such as interface failure) based on the output of the heat flow sensor 29A. The lifetime of the semiconductor module 2 is determined, for example, using a table in which the lifetime corresponding to the output of the heat flow sensor 29A (an output index obtained by normalizing or correcting the output) is defined, or a function that calculates the lifetime using the output of the heat flow sensor 29A as an argument. The determination unit 434 may also input condition parameters such as the output of the heat flow sensor 29A and the temperature of the semiconductor module 2 into a lifetime determination model stored in the storage unit 42, and may cause the lifetime determination model to output the lifetime of the semiconductor module 2. The lifetime determination model is a trained model learned using training data that combines condition parameters and the length of lifetime.

### <Output Unit 435>

The output unit 435 is configured to output various kinds of information. An external device (not shown) can perform various controls based on the information output from the output unit 435. For example, the external device may estimate the temperature of a measurement object based on the information output from the output unit 435 and control the driving aspect of the measurement object based on the estimated temperature. The output unit 435 can also present such information and the like to the user via the display unit 44 of the information processing apparatus 4 or via another device. In this case, for example, the output unit 435 controls the display unit 44 of the information processing apparatus 4 to display visual information such as screens, images including still or moving images, icons, messages and the like. The output unit 435 may generate only rendering information for displaying the visual information on the information processing apparatus 4. Note that the output unit 435 may present the output information to the user not via the information processing apparatus 4 or any other devices.

In particular, the output unit 435 outputs an alert indicating the occurrence of an abnormality determined by the determination unit 434, as well as information such as the lifetime, to the user as visual information or auditory information.

### 4. Information Processing

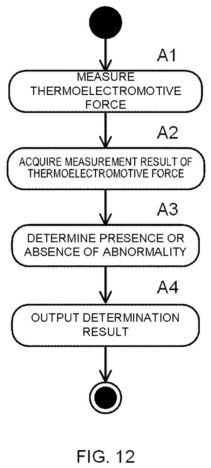

This section describes information processing to be executed in the above abnormality determination system 1. FIG. 12 is an activity diagram showing an example of a flow of information processing executed in the abnormality determination system 1. The information processing may include any exception processing not shown. The exception processing includes interruption of the information processing and omission of each process. Selection or input performed in the information processing may be based on operations by the user, or may be automatic not by the user's operations.

### [Activity A1]

First, in Activity A1, the electric power measuring device 3 measures a thermoelectromotive force V output from the heat flow sensor 29A. Accordingly, the electric power measuring device 3 acquires respective thermoelectromotive forces V of the first thermoelectric conversion devices 292A and respective thermoelectromotive forces V of the second thermoelectric conversion devices 292B included in the heat flow sensor 29A. Thereafter, the electric power measuring device 3 outputs the acquired results to the information processing apparatus 4. For example, the electric power measuring device 3 outputs the measured values themselves of the respective thermoelectromotive forces V of the first thermoelectric conversion devices 292A and second thermoelectric conversion devices 292B. The output aspect of the thermoelectromotive force V by the electric power measuring device 3 is arbitrary; for example, it may output the average value of the thermoelectromotive forces V of the plurality of first thermoelectric conversion devices 292A and the average value of the thermoelectromotive forces V of the plurality of second thermoelectric conversion devices 292B. That is, the electric power measuring device 3 outputs the measurement results in any manner that allows the thermoelectromotive force V corresponding to the first thermoelectric conversion device 292A to be distinguished from the thermoelectromotive force V corresponding to the second thermoelectric conversion device 292B.

### [Activity A2]

Next, the process proceeds to Activity A2, where the acquisition unit 431 acquires a thermoelectromotive force V of the first thermoelectric conversion device 292A and a thermoelectromotive force V of the second thermoelectric conversion device 292B measured by the electric power measuring device 3 in Activity A1. Note that the thermoelectromotive force V measured by the electric power measuring device 3 is not limited to the actual value of the thermoelectromotive force V output from the measurement terminals 2924 of the thermoelectric conversion unit 292, but may include a value obtained by applying any of the above-described processing to the thermoelectromotive force V acquired by the electric power measuring device 3.

The acquisition unit 431 also acquires information such as the temperature of the semiconductor module 2, the ambient temperature of the semiconductor module 2, and the power supplied to the semiconductor module 2 directly from the semiconductor module 2 or via the electric power measuring device 3.

### [Activity A3]

Next, the process proceeds to Activity A3, where the determination unit 434 executes determination of the presence or absence of an abnormality (and, as necessary, determination of the lifetime) of the semiconductor module 2 using parameters such as the thermoelectromotive force V acquired in Activity A2.

### [Activity A4]

Next, the process proceeds to Activity A4, where the output unit 435 outputs the determination result obtained in Activity A3. Note that the output unit 435 may output the result only when the determination unit 434 determines that an abnormality has occurred, and may refrain from outputting the result when the determination unit 434 determines that no abnormality has occurred.

The thermoelectromotive force V acquired by the acquisition unit 431 may be converted by the calculation unit 433 into a predetermined voltage value based on the designation received by the designation unit 432. The voltage value calculated by the calculation unit 433 may be output, for example, to an external device by the output unit 435. This enables control of the external device in accordance with the temperature of the measurement object, and allows the external device to detect light, chemical substances, and the like.

### 5. Heat Flow Measurement Method

This section describes an abnormality determination method using the abnormality determination system 1. The abnormality determination method includes an acquisition step and a determination step. The acquisition step is a step of acquiring an output of the heat flow sensor 29A disposed at a position where heat flow associated with heat generation of the semiconductor device 24 mounted on the circuit board 21 in the semiconductor module 2 occurs. The determination step is a step of determining an abnormality of the semiconductor module 2 based on the output of the heat flow sensor 29A. With such a configuration, heat retention accompanying interface delamination between members of the semiconductor module 2 can be detected by the heat flow sensor 29A. This enables prediction of the occurrence of abnormalities in the semiconductor module 2, which is less susceptible to influences of the usage environment.

### 6. Others

The above-described aspects of the abnormality determination system 1 are just examples, and the present disclosure is not limited to those.

In the present embodiment, the electric power measuring device 3 and the information processing apparatus 4 are provided as separate devices; however, these may be integrated. The electric power measuring device 3 may also include the respective functional units of the information processing apparatus 4 (the acquisition unit 431, the designation unit 432, the calculation unit 433, the determination unit 434, and the output unit 435). Accordingly, the above-described information processing may be performed by the electric power measuring device 3.

The calculations performed by the calculation unit 433 in the abnormality determination system 1 are not limited to calculation using digital signals. The calculation may involve analog circuits using adder circuits or the like, or a combination of digital and analog calculation may also be adopted.

In the present embodiment, the electric power measuring device 3 may be disposed on the same substrate (for example, the insulation part 291) as the heat flow sensor 29A. In other words, the heat flow sensor 29A and the electric power measuring device 3 may be arranged on-board on a single substrate.

Furthermore, the heat flow sensor 29A and the electric power measuring device 3 may be configured to communicate wirelessly. That is, the electric power measuring device 3 may measure the thermoelectromotive force V through wireless communication with the heat flow sensor 29A. In this case, the heat flow sensor 29A may not need to include the port 294.

The information processing executed in the external device of the heat flow sensor 29A, such as the electric power measuring device 3 and the information processing apparatus 4 may be on-premises or in-cloud. The in-cloud external device may provide the above-described functions and processing in a form of, for example, cloud computing such as SaaS (Software as a Service).

In the above-described embodiment, the electric power measuring device 3 and the information processing apparatus 4 execute various storage and control operations, but a plurality of external devices may be used instead of the electric power measuring device 3 and the information processing apparatus 4. In other words, various types of information and programs may be divided to be stored into the plurality of the external devices by using blockchain technology or the like.

The above embodiment is not limited to the abnormality determination system 1, and may be an information processing method or an information processing program. The information processing method includes each step of the abnormality determination system 1. The information processing program allows at least one computer to execute each step of the abnormality determination system 1.

The above-described abnormality determination system 1 and the like may be provided in each of the following aspects.
(1) A semiconductor module, comprising: a circuit board on which a semiconductor device is mounted; and a heat flow sensor disposed at a position where heat flow associated with heat generation of the semiconductor device occurs.

With such a configuration, heat retention accompanying interface delamination between members of the semiconductor module can be detected by the heat flow sensor, thereby enabling prediction of the occurrence of abnormalities in the semiconductor module, which is less susceptible to influences of the usage environment.

(2) The semiconductor module according to (1), wherein: the heat flow sensor includes a thermoelectric conversion unit configured, on a basis of an anomalous Nernst effect, to convert a thermal gradient generated through heat exchange with a measurement object into an electric signal.

With such a configuration, the sensitivity and time response of the heat flow sensor can be enhanced compared to when the Seebeck effect is utilized.

(3) The semiconductor module according to (1) or (2), wherein: the circuit board includes a substrate layer, and a wiring layer laminated on the substrate layer, and the heat flow sensor is disposed on a surface of the substrate layer or on a surface of the wiring layer.

With such a configuration, the heat flow sensor can be formed on the substrate layer or the wiring layer of the circuit board, thereby facilitating manufacture of the semiconductor module.

(4) The semiconductor module according to (3), wherein: the heat flow sensor is disposed between the substrate layer and the wiring layer.

With such a configuration, the heat flow sensor can be formed inside the circuit board, thereby improving the accuracy of heat-flow detection.

(5) The semiconductor module according to any one of (1) to (4), wherein: the heat flow sensor is disposed on an outer surface of the semiconductor device.

With such a configuration, the heat flow sensor can be installed after the semiconductor device is mounted on the circuit board, and thus the manufacture of the semiconductor module is facilitated.

(6) The semiconductor module according to any one of (1) to (5), further comprising: an auxiliary member that supports or surrounds the circuit board, wherein the heat flow sensor is disposed on an outer surface of the auxiliary member.

With such a configuration, the heat flow sensor can be installed after assembling the circuit board onto the auxiliary member, and thus the manufacture of the semiconductor module is facilitated.

(7) An abnormality determination system, comprising: a heat flow sensor disposed at a position where heat flow occurs, the heat flow being associated with heat generation of a semiconductor device mounted on a circuit board in a semiconductor module; and an information processing apparatus configured to determine an abnormality of the semiconductor module based on an output of the heat flow sensor.

With such a configuration, heat retention accompanying interface delamination between members of the semiconductor module can be detected by the heat flow sensor, thereby enabling prediction of the occurrence of abnormalities in the semiconductor module, which is less susceptible to influences of the usage environment.

(8) The abnormality determination system according to (7), wherein: the information processing apparatus is configured to determine the abnormality based on the output of the heat flow sensor and a temperature of the semiconductor module.

With such a configuration, it becomes possible to determine an abnormality taking into consideration the temperature dependence of the heat capacity, thermal resistance and the like of the heat flow sensor, thereby improving the accuracy of abnormality determination.

(9) The abnormality determination system according to (7) or (8), wherein: the information processing apparatus is configured to determine the abnormality based on the output of the heat flow sensor and power supplied to the semiconductor module.

With such a configuration, the output of the heat flow sensor can be normalized based on the supplied power, thereby reducing disturbances. As a result, the accuracy of abnormality determination can be improved.

(10) An abnormality determination method, comprising: an acquisition step of acquiring an output of a heat flow sensor disposed at a position where heat flow occurs, the heat flow being associated with heat generation of a semiconductor device mounted on a circuit board in a semiconductor module; and a determination step of determining an abnormality of the semiconductor module based on the output of the heat flow sensor.

With such a configuration, heat retention accompanying interface delamination between members of the semiconductor module can be detected by the heat flow sensor, thereby enabling prediction of the occurrence of abnormalities in the semiconductor module, which is less susceptible to influences of the usage environment.

Of course, the present disclosure is not limited to the above aspects.

Finally, various embodiments of the present disclosure have been described, but these are presented as examples and are not intended to limit the scope of the invention. Novel embodiments can be implemented in various other forms, and various omissions, replacements, and modifications can be made within the scope of the spirit of the invention. The embodiment and its modifications are included in the scope and the spirit of the invention and are included in the scope of the invention described in claims and the equivalent scope thereof.

### REFERENCE SIGNS LIST

1: Abnormality determination system
2: Semiconductor module
3: Electric power measuring device
4: Information processing apparatus
6: Printed circuit board
7: Heat sink
21: Circuit board
22: Base
23: Bonding layer
24: Semiconductor device
25A: First terminal
25B: Second terminal
26A: Frame body
26B: Sealing material
27: Bonding wire
29A: Heat flow sensor
29B: Heat flow sensor
29C: Heat flow sensor
29D: Heat flow sensor
29E: Heat flow sensor
29F: Heat flow sensor
29G: Heat flow sensor
29H: Heat flow sensor
29I: Heat flow sensor
29J: Heat flow sensor
29K: Heat flow sensor
29L: Heat flow sensor
29M: Heat flow sensor
40: Communication bus
41: Communication unit
42: Storage unit
43: Processor
44: Display unit
45: Input unit
211: Substrate layer
212: First wiring layer
213: Second wiring layer
241: Device main body
242: Adhesive layer
291: Insulation part
292: Thermoelectric conversion unit
292A: First thermoelectric conversion device
292B: Second thermoelectric conversion device
294: Port
431: Acquisition unit
432: Designation unit
433: Calculation unit
434: Determination unit
435: Output unit
2920: Substrate
2921: Thermoelectric conversion element
2922: First conductor
2923: Second conductor
2924: Measurement terminal
H: Heat flow

## Claims

1. A semiconductor module, comprising:
a circuit board on which a semiconductor device is mounted; and
a heat flow sensor disposed at a position where heat flow associated with heat generation of the semiconductor device occurs.

2. The semiconductor module according to claim 1, wherein:
the heat flow sensor includes a thermoelectric conversion unit configured, on a basis of an anomalous Nernst effect, to convert a thermal gradient generated through heat exchange with a measurement object into an electric signal.

3. The semiconductor module according to claim 1 or 2, wherein:
the circuit board includes a substrate layer, and a wiring layer laminated on the substrate layer, and
the heat flow sensor is disposed on a surface of the substrate layer or on a surface of the wiring layer.

4. The semiconductor module according to claim 3, wherein:
the heat flow sensor is disposed between the substrate layer and the wiring layer.

5. The semiconductor module according to any one of claims 1 to 4, wherein:
the heat flow sensor is disposed on an outer surface of the semiconductor device.

6. The semiconductor module according to any one of claims 1 to 5, further comprising:
an auxiliary member that supports or surrounds the circuit board, wherein
the heat flow sensor is disposed on an outer surface of the auxiliary member.

7. An abnormality determination system, comprising:
a heat flow sensor disposed at a position where heat flow occurs, the heat flow being associated with heat generation of a semiconductor device mounted on a circuit board in a semiconductor module; and
an information processing apparatus configured to determine an abnormality of the semiconductor module based on an output of the heat flow sensor.

8. The abnormality determination system according to claim 7, wherein:
the information processing apparatus is configured to determine the abnormality based on the output of the heat flow sensor and a temperature of the semiconductor module.

9. The abnormality determination system according to claim 7 or 8, wherein:
the information processing apparatus is configured to determine the abnormality based on the output of the heat flow sensor and power supplied to the semiconductor module.

10. An abnormality determination method, comprising:
an acquisition step of acquiring an output of a heat flow sensor disposed at a position where heat flow occurs, the heat flow being associated with heat generation of a semiconductor device mounted on a circuit board in a semiconductor module; and
a determination step of determining an abnormality of the semiconductor module based on the output of the heat flow sensor.
